# EUROPEAN PATENT APPLICATION

(11) **EP 1 965 420 A2**
(43) Date of publication of application: **03.09.2008**
(21) Application number: 08151654.4
(22) Date of filing: 20.02.2008
(51) Int. Cl.: H01L 21/56, B29C 45/14

(54) **Compliant pin strip with integrated dam bar**

(30) Priority: 01.03.2007 US 712750
(71) Applicant: Delphi Technologies, Inc., Troy, Michigan 48007 (US)
(72) Inventor: Brandenburg, Scott D., Kokomo, IN 46902 (US); Laudick, David A., Kokomo, IN 46901 (US)
(74) Representative: Robert, Vincent

(57) **Abstract**

An improved compliant pin strip and process for making an electrical package having a printed circuit board encased in a housing and pin connectors mechanically and electrically connected to the printed circuit board and extending outwardly away from an outer surface of the housing is provided. This involves the use of a compliant pin strip having a dam bar that defines surfaces for a molding tool to close on and seal a mold cavity. The pin strip with dam bar enables a simplified, cost effective, and more robust manufacturing process.

## Description

### Technical Field

This invention relates to the field of electrical packages and more particularly to electrical packages utilizing compliant pin connectors.

### Background of the Invention

Encased electronic packages with a plurality of pin connectors have typically been prepared by utilizing wave soldering to physically and electrically attach a plurality of pin connectors to a printed circuit board. The use of wave soldering has been favored primarily due to the resulting superior mechanical strength of the attachment and the low process costs associated with wave soldering. Alternatively, pin-in-paste techniques may be used for electrically and mechanically attaching pin connectors to a printed circuit board. This technique involves applying solder paste to a through hole in the printed circuit board, inserting a connector pin into the solder paste, and then using a reflow soldering technique to achieve a mechanically and electrically robust attachment of the connector pin to the through hole. Although these processes have proven satisfactory, improved processes that are less cumbersome and expensive are desirable.

### Summary of the Invention

The invention provides an improved technique for fabricating an electrical package having a printed circuit board encased in a housing and pin connectors mechanically and electrically connected to the printed circuit board and extending outwardly away from an outer surface of the housing. The process involves first providing a compliant pin strip comprising a plurality of compliant pins that are held together in a spaced apart relationship. At one end of each of the pins there is a compliant portion used for achieving a compliant pin or press-fit connection with a corresponding compliant pin receiving hole in a printed circuit board. A dam bar comprises aligned members that extend between adjacent pins transversely of the length direction of the pins. The dam bar and pins together define surfaces for a molding tool to close on and seal a mold cavity during a molding step. In accordance with the invention, the compliant portion of each of the plurality of compliant pins is inserted into a corresponding compliant pin receiving hole in a printed circuit board to attach the compliant pin strip to the printed circuit board and thereby make an electrical connection between the printed circuit board and each of the compliant pins. The printed circuit board with the attached compliant pin strip is then positioned in a molding tool, and the molding tool is closed so that the printed circuit board is contained within a mold cavity defined by the closed molding tool, and so that molding tool surfaces close on surfaces of the dam bar and pins to seal around the dam bar during a molding step. A moldable plastic material is then introduced into the mold cavity. The moldable plastic material is allowed to solidify and form an enclosure for the printed circuit board assembly with a portion of each of the compliant pins projecting outwardly away from a surface of the housing.

These and other features, advantages and objects of the present invention will be further understood and appreciated by those skilled in the art by reference to the following specification, claims and appended drawings.

### Brief Description of the Drawings

The present invention will now be described, by way of example, with reference to the accompanying drawings, in which:
FIG. 1 is a plan view of a compliant pin strip in accordance with the invention.
FIG. 2 is a perspective view of the compliant pin strip of FIG. after a shaping operation.
FIG. 3 is a perspective view of the shaped compliant pin strip of FIG. 2 attached to a printed circuit board.
FIG. 4 is a perspective view of a finished connector package assembly with the circuit board and compliant pin shown in dashed lines.
FIG. 5 is a perspective view of the completed connector package assembly.

### Description of the Preferred Embodiments

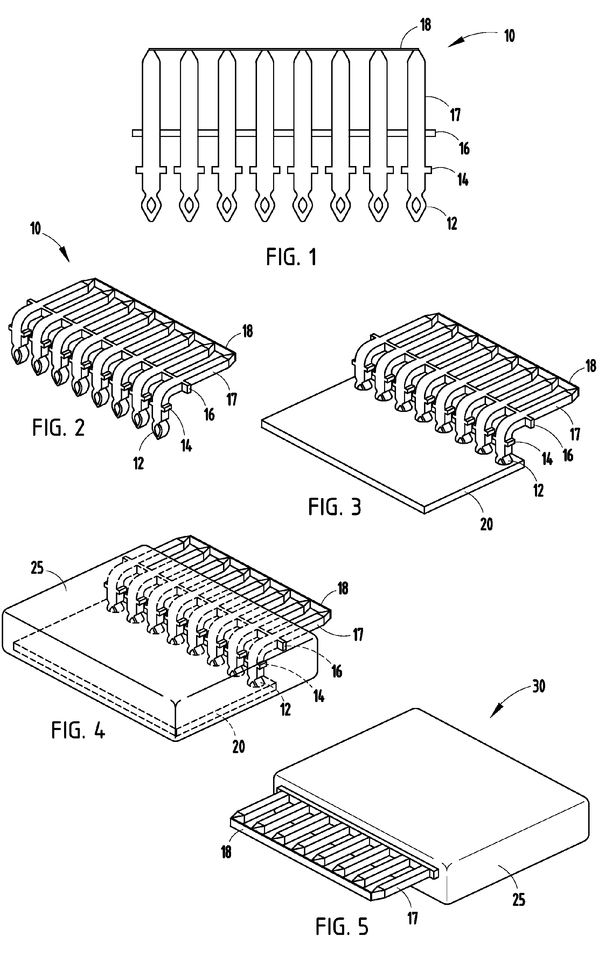

Shown in FIG. 1 is a compliant pin strip 10 with an integrated dam bar 16. The strip 10 comprises a plurality of generally parallel spaced apart electrically conductive compliant pins having a conventional compliant pin portion 12 for achieving a compliant pin or press-fit connection with a through-hole in a printed circuit board 20 that mechanically and electrically joins each of pins 17 to the printed circuit board (FIG. 3). At the end of each pin 17 opposite the compliant end portion is a distal end that may be used to connect with an external device. Dam bar 16 comprises a plurality of strip-like members that extend between adjacent pins 17 transversely of the length direction of pins 17. In the illustrated embodiment, dam bar 16 is located approximately midway between the ends of the pins. However, some variation in the location of the dam bar is acceptable, provided that the dam bar does not interfere with interconnection of the compliant portion 12 with a corresponding compliant pin receiving hole in the printed circuit board, and provided that it is located sufficiently from the end opposite the compliant portion 12 to allow portions of the pins to project outwardly away from a surface of a housing as shown in FIGS. 4 and 5.

Pressure tabs 14 may optionally be provided adjacent the compliant portions 12 to provide bearing surfaces for applying pressure to insert the compliant portions 12 into the corresponding receiving holes provided in a printed circuit board. A pin tie-down strip 18 may be provided to connect the ends of the pins opposite the compliant portion ends 12 of the pins, such as to maintain a generally parallel spaced apart relationship of the pins during a shaping operation of the compliant pin strip 10, if necessary.

Compliant pin strip 10 is made of an electrically conductive material (e.g., a metal) and may be formed by using a stamping technique.

As shown in FIG. 2, pin strip 10 may be shaped or bent in a tool so that the portions of the pins projecting from housing 25 extend at a right angle to the portions of the pins that are inserted into the circuit board 20.

After the compliant portions 12 have been inserted into compliant portion receiving holes defined in printed circuit board 20, the printed circuit board and attached strip 10 is inserted into a mold cavity of a molding tool, and the molding tool is closed around the dam bar so that surfaces of the molding tool mate with surfaces of the dam bar to seal the mold cavity. After the mold is closed, a moldable plastic material is injected into the mold cavity. Suitable moldable plastic materials include molten thermoplastics and curable thermosetting compositions. In the case of thermoplastic materials, a housing encasing the printed circuit board 20 is made by cooling the moldable plastic material and thereby solidifying the housing 25. In the case of thermosetting materials, curing or cross-linking may be heat initiated or initiated in another suitable manner to cause the liquid thermosetting material to solidify and form housing 25.

A substantially completed connector package having a circuit board 20 encased in a housing 25 with pin connectors 17 mechanically and electrically connected to the circuit board and extending outwardly away from an outer surface of housing 25 is shown in FIG. 5.

After molding is completed, the dam bar and pin tie-down strip 10 are sheared away to singulate pins 17.

The techniques employed in accordance with the invention result in a simplified, cost effective, and more robust manufacturing process. Overmolding compliant pins results in increased reliability and may enable the use of thinner printed circuit boards.

It will be understood by those who practice the invention and those skilled in the art that various modifications and improvements may be made to the invention without departing from the spirit of the disclosed concept. The scope of protection afforded is to be determined by the claims and by the breadth of interpretation allowed by law.

## Claims

1. A process for fabricating an electrical package having a circuit board encased in a housing and pin connectors mechanically and electrically connected to the circuit board and extending through the housing and outwardly away from an outer surface of the housing, comprising:
providing a compliant pin strip comprising a plurality of compliant pins that are held together in a spaced apart relationship, a compliant portion at one end of each pin, a dam bar comprising aligned members that extend between adjacent pins transversely of the length direction of the pins, the dam bar and pins defining surfaces for a molding tool to close on and seal a mold cavity;
inserting the compliant portion of each of the plurality of compliant pins and a corresponding compliant pin receiving hole in a printed circuit board to attach the compliant pin strip to the printed circuit board and thereby make an electrical connection between the printed circuit board and each of the compliant pins;
positioning the printed circuit board with the attached compliant pin strip on a molding tool and closing the molding tool so that the printed circuit board is contained within a mold cavity defined by the closed molding tool and so that surfaces of the molding tool close on surfaces of the dam bar and pins to seal around the dam bar;
introducing a moldable plastic material into the mold cavity; and
solidifying the moldable plastic material to form a housing for the printed circuit board with portions of the compliant pins projecting outwardly away from a surface of the housing.

2. The process of claim 1, wherein the compliant pin strip includes a tie-down strip connecting ends of the pins opposite the compliant portion end of the pins.

3. The process of claim 1, wherein the moldable plastic material is a thermoplastic.

4. The process of claim 1, wherein the moldable plastic material is a thermosettable resin.

5. The process of claim 1, wherein the pin strip is bent before introducing a moldable plastic material into the mold cavity.

6. A compliant pin strip comprising:
a plurality of compliant pins held together in a spaced apart relationship, each pin having a compliant end portion and an opposite distal end portion; and
a dam bar comprising aligned members that extend between adjacent compliant pins transversely of the length direction of the pins, the dam bar being located between opposite ends of the pins.

7. The compliant pin strip of claim 6, further comprising pressure tabs adjacent the compliant end portions to provide bearing surfaces for applying pressure to insert the compliant portions into receiving holes of a printed circuit board.

8. The compliant pin strip of claim 7, further comprising a tie-down strip connecting the distal end portions of the compliant pins.
